# EUROPEAN PATENT APPLICATION

(11) **EP 3 327 984 A1**
(43) Date of publication of application: **30.05.2018**
(21) Application number: 16200554.0
(22) Date of filing: 24.11.2016
(51) Int. Cl.: H04L 5/14, H04L 5/00, H01P 1/15

(54) **FULL-DUPLEX SWITCHING MODULE AND METHOD**

(71) Applicant: TE Connectivity Nederland B.V., 5222 AR 's Hertogenbosch (NL)
(72) Inventor: ROUSSTIA, Mohadig Widha, 5612 DZ Eindhoven (NL); SHARMA, Rohit, 5611 KS Eindhoven (NL); HABRAKEN, Gied, 5551 HX Valkenswaard (NL)
(74) Representative: Grünecker Patent- und Rechtsanwälte PartG mbB

(57) **Abstract**

The present invention relates to a switching module for establishing a controllable propagation path for a high-frequency modulated signal in response to switching information and to a corresponding method of establishing a controllable propagation path. A switching module comprises a controllable switch (102) for coupling a first port to one of at least a second port and an N^{th} port, N being an integer greater than or equal to 3,, and a link-management unit (104) that is operable to generate a control signal for controlling said switch (108) based on the switching information, wherein the link-management unit (104) comprises a detector unit (126) that is operable to receive the control signal together with the high-frequency modulated signal and to generate a switching pulse (128) for controlling the switch (102) depending on the control signal.

## Description

The present invention relates to a switching module for establishing a controllable propagation path for a high-frequency modulated signal in response to switching information and to a corresponding method of establishing a controllable propagation path.

The present invention is particularly advantageous when switching signals that are transmitted via millimeter wave signals and can advantageously be combined with so-called polymer millimeter wave fibers (PMF, also called plastic waveguides in the following). In the context of the present invention the millimeter wave frequency range is referring to signals with a frequency between 30 GHz and 300 GHz, for instance 60 GHz. By making use of carrier frequencies in this frequency domain, wide band communication systems benefit from the large bandwidth available. One of today's challenges is to transmit these millimeter wave carriers over a distance of several meters to provide a Gbps communication link. Because wireless transmission in this frequency range suffers from increased free space path-loss, plastic waveguides are often used. Plastic waveguides benefit from the low inherent transmission loss of the polymer in the millimeter wave frequency domain. Consequently plastic waveguides have the advantage of providing a low loss, cost friendly and lightweight guided channel.

When switching signals that are transmitted via plastic fibers/waveguides to predetermined destinations, it is important that the switching device processes the information to which particular destination the signal is bound to switch. Conventional switching systems use address information that is encoded in a header of data packets containing the payload information as a data filed. The address information has to be decoded and processing of this information is performed not in the physical layer, but in a higher communication layer.

Furthermore, large network switching systems use lookup tables which need to be updated and require a certain degree of complexity in the electronic circuits of the switching system. Hence, the delay in data communication is increased to an often unacceptable level.

There is a need to provide a switching module and a corresponding method for establishing a controllable propagation path for a high-frequency modulated signal that has a low latency, can be realized at low cost and that is robust and reliable even under harsh environmental conditions such as for automotive and industrial applications.

This object is solved by the subject matter of the independent claims. Advantageous embodiments of the present invention are the subject matter of the dependent claims.

The present invention is based on the idea to provide the switching information, i. e. the address (or port) whereto a signal is to be directed, in a way that it can be transmitted and evaluated in the physical layer domain without the need to transform it into a higher layer domain. In particular, according to the present invention, a switching module for establishing a controllable propagation path for a high-frequency modulated signal in response to a switching information comprises a controllable switch for coupling a first port to one of at least a second port and a third port, generally coupling a first port to one of at least a second port and an N^{th} port, N being an integer greater than or equal to 3, and a link-management unit that is operable to generate a control signal for controlling said switch based on the switching information.

According to the present invention, the link-management unit comprises a detector unit that is operable to receive the control signal together with the high-frequency modulated signal and to generate a switching pulse for controlling the switch depending on the control signal. The control signal is transmitted over a channel separated from the high-frequency modulated signal by frequency division or time division within a common wave guide. Alternatively, the control signal may also be via a separate physical channel, e. g. via a wireless connection. In any case, the high-frequency modulated signal does not have to be transformed or demodulated in order to extract the address information that is provided to the controllable switch, but stays unaltered in its carrier frequency without down or up conversion.

The advantage of this solution can firstly be seen in a significant reduction of the signal delay and therefore of the system latency. For instance, when using this concept for switching 60 GHz modulated signals, switch latency of less than 10 ns can be achieved. Moreover, the communication over the established channel may be bidirectional if needed. In other words, a full-duplex transmission channel can be switched with a switching module according to the present invention. Furthermore, no higher layer decoding and addressing structures and no look-up tables have to be provided, thus the switching architecture is simple, cost efficient and robust.

According to an advantageous embodiment of the present invention, the switching module comprises a control signal generating unit having a latch circuit having a data input terminal, a latch enable terminal, and an output terminal, wherein the high-frequency modulated signal is input into the data input terminal and wherein the output terminal is connected to a control signal generator for triggering a control signal. Thereby, a control signal which contains the address information can be generated in a particularly efficient way. Moreover, a digital latch circuit allows generating the control signal at a particular time slot where the high-frequency modulated signal has to be switched. Such a latch circuit introduces a delay of about 4 ns. According to the present invention, the controllable switch comprises a GaAs monolithic microwave integrated circuit. Such monolithic switch dies are available from a plurality of manufacturers and have the advantage of maintaining the signal integrity, of providing adequate impedance matching at the input and output ports, and of a small size.

According to a further advantageous embodiment, the detector unit comprises at least a first and a second band pass filter for receiving the control signal and at least a first and a second Schmitt trigger, the first Schmitt trigger being connected with its input to the output of the first band pass filter for generating a trigger pulse in response to an output signal being present at the output of the first band pass filter, and the second Schmitt trigger being connected with its input to the output of the second band pass filter for generating a trigger pulse in response to an output signal being present at the output of the second band pass filter. With this architecture frequency division coded control signals can easily be detected and converted into a switching command that controls the controllable switch to direct the signal to a particular port. Generally speaking, the controllable switch establishes a continuous conductive path between two ports as indicated by the control signal. The continuous conductive path can transmit signals bidirectionally, i.e. provides a full-duplex communication path.

In order to allow for receiving the control signal from the other direction in case of a bidirectional communication" the switching module may advantageously comprise a second detector unit for detecting a control signal transmitted with a high-frequency modulated signal received at the second or third port, wherein the propagation path is a full-duplex transmission path. This is useful for a master-master type of network (rather than a master-slave network).

For attaching millimeter wave conducting fibers in a simple manner without introducing unnecessary losses, the switching module comprises fiber coupling antennas for coupling a millimeter wave conducting fiber to each of the first, second, and third ports. Generally, an arbitrary number of N ports can be provided on either side of the switching module.

Advantageously, the control signal comprises pulses which modulate different frequencies for encoding the switching information. This means the switching information is encoded in a frequency division coding. Alternatively, also a time division coding or code division coding may be employed according to the present invention.

The switching module according to the present invention may further comprise power amplification means for amplifying the high-frequency modulated signal. This has the advantage that a signal that has intensity loss can be refreshed when passing through the switching module.

The present invention also relates to a corresponding method of establishing a controllable propagation path for a high-frequency modulated signal in response to a switching information, wherein the method comprises the following steps:
generating the control signal for controlling a controllable switch based on the switching information,
coupling a first port to one of at least a second port and a third port by means of the controllable switch,
wherein the control signal is transmitted together with the high-frequency modulated signal and wherein a switching pulse is generated for controlling the switch depending on the control signal.

According to an advantageous embodiment, the control signal is generated in a defined time slot. Furthermore, generating the switching pulse may comprise filtering the control signal and inputting the filtered control signal into a trigger stage, wherein the trigger stage generates the switching pulse. For instance, band pass filters can be used to extract frequency modulated control signals indicating a particular propagation path that has to be established by the controllable switch.

According to a further embodiment of the present invention, the control signal is generated from switching information transmitted with the high-frequency modulated signal over a millimeter wave fiber. This solution has the advantage that no additional signal transmission and reception means have to be provided. Alternatively, the control signal is generated from switching information transmitted simultaneously with the high-frequency modulated signal over a wireless communication channel. In this case, the bandwidth and transmission capacity for the payload data is not influenced by the transmission of the control signal. As already mentioned above, the control signal may be generated as a frequency multiplexed or code multiplexed signal.

Advantageously, the signals can be transmitted in both directions i. e. the controllable propagation path is a full-duplex transmission path.

The accompanying drawings are incorporated into the specification and form a part of the specification to illustrate several embodiments of the present invention. These drawings, together with the description, serve to explain the principles of the invention. The drawings are merely for the purpose of illustrating the preferred and alternative examples of how the invention can be made and used, and are not to be construed as limiting the invention to only the illustrated and described embodiments.

Furthermore, several aspects of the embodiments may form-individually or in different combinations-solutions according to the present invention. Further features and advantages will become apparent from the following more particular description of the various embodiments of the invention as illustrated in the accompanying drawings, in which like references refer to like elements, and wherein:
- **FIG. 1**: is a schematic diagram of a switching module according to a first embodiment of the present invention;
- **FIG. 2**: is a schematic diagram of a control signal generating unit according to an advantageous embodiment of the present invention;
- **FIG. 3**: is a schematic diagram of a switching module according to a further embodiment of the present invention;
- **FIG. 4**: is a schematic diagram of a detector unit according to an advantageous embodiment of the present invention.

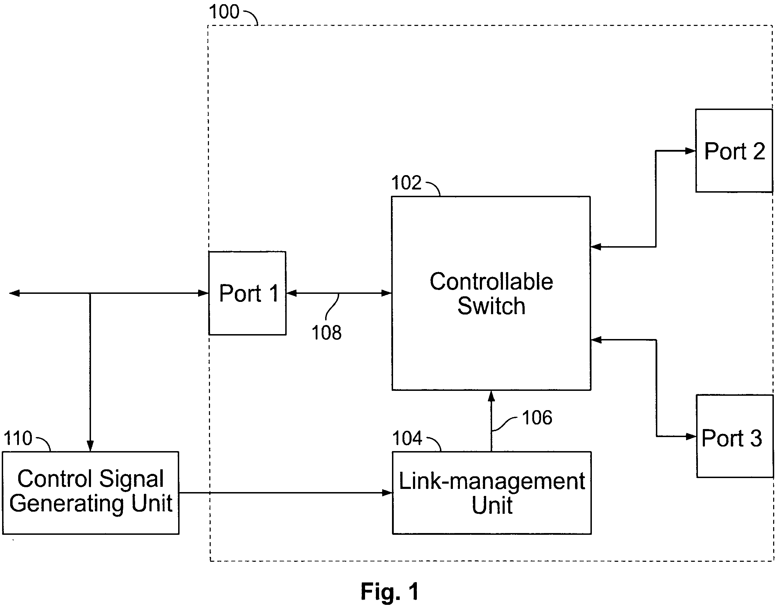

The present invention will now be explained in more detail with reference to the Figures. Referring to Fig. 1, a schematic overview diagram of a switching module 100 according to a first embodiment of the present invention is shown. In the most basic architecture, the switching module 100 establishes a controllable propagation path for a high-frequency modulated signal 108 from port 1 either to port 2 or to port 3. A control signal for controlling the selection of the propagation path is generated by means of an external control signal generating unit 110.

The high-frequency modulated signal 108 refers to a millimeter wave signal, i. e. to signals with a frequency between 30 GHz and 300 GHz, for instance 60 GHz. This frequency is not altered when gating the signal through the switching module 100, in particular, no up or down conversion is needed.

The physical gating function is performed by a controllable switch 102. The controllable switch 102 may for instance comprise a GaAs monolithic microwave integrated circuit (MMIC) switch. Such MMIC switches are available in chip sizes of only several thousand and square micrometers and therefore allow a particularly space-saving overall design of the switching module 100. Although fig. 1 only shows a controllable propagation path between one port on one side of the switch and two selectable ports on the other side of the switch, it is clear for a person skilled in the art that any other constellation may of course also be covered by the present invention. The switch 102 may for instance be able to establish a propagation path between more than two selectable ports on each side.

For controlling the controllable switch 102 the switching unit 100 further comprises a link-management unit 104. As shown in fig. 1, the link-management unit 104 is connected to port 1 and receives the high-frequency modulated signal that is input at port 1 for extracting the control signal therefrom. Based on the extracted control signal, the link management unit 104 generates a switching pulse 106 that controls the controllable switch 102 to connect port 1 either to port 2 or to port 3. According to the present invention, the link-management unit 104 does not perform any decoding on the high-frequency modulated signal 108, but derive the control information by means of a latching circuit and a detecting unit, as this will become more apparent from the following figures.

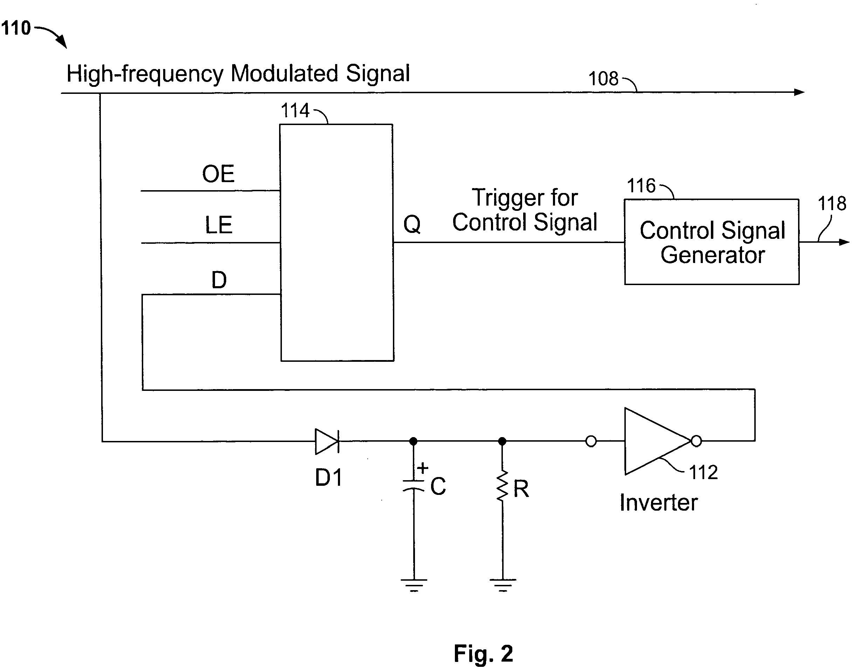

Figure 2 shows a control signal generating unit 110 according to an advantageous embodiment of the present invention. The control signal generating unit 110 is provided externally to the switching module 100. Its purpose is to generate the control signal from a device (such as a switch control or a microcontroller in a signal source, when considering the switching module as the signal sink) and to later inform the switching module 100 to indicate a correct port to which the signal has to be switched. This generated control signal is interpreted in the link-management unit 104 of the switching module 100, in particular by the detector unit 126.

The control signal generating unit 110 is connected to the high-frequency modulated signal which is input via a diode D1 and an inverter 112 into the data input terminal D of a latch circuit 114. The latch circuit 114 may for instance be formed by a commercially available integrated circuit, such as the SN74LVC1 G373 single D-type latch by the company Texas instruments. It is of course clear for a person skilled in the art that any other suitable latch circuit may also be used in the control signal generating unit 110 according to the present invention. The latch circuit 114 comprises a latch enable terminal LE and an output and enable terminal OE. While the latch enable input LE is high, the Q output follows the data input at the data terminal D. When LE is taken low, the Q output is latched at the logic level set up by the D input. The control signal generating unit 110 is thereby able to generate a control signal which contains the address information. By providing respective enable signals, the control signal can be generated at a particular timeslot where the high-frequency modulated signal has to be switched.

It could be shown that the latch circuit introduces a delay of about 4 ns, thus causing only a minimal latency. A control signal generator 116 provides the actual control signal, for instance a pulse having a predetermined frequency different from the frequency of the high-frequency modulated signal.

According to the present invention, the control signal 118 generated by the control signal generator 116 may for instance be transmitted to the link management unit 104 via the same PMF as the high-frequency modulated signal. Alternatively, the control signal 118 may also be received by the link-management circuit 104 via a wireless channel.

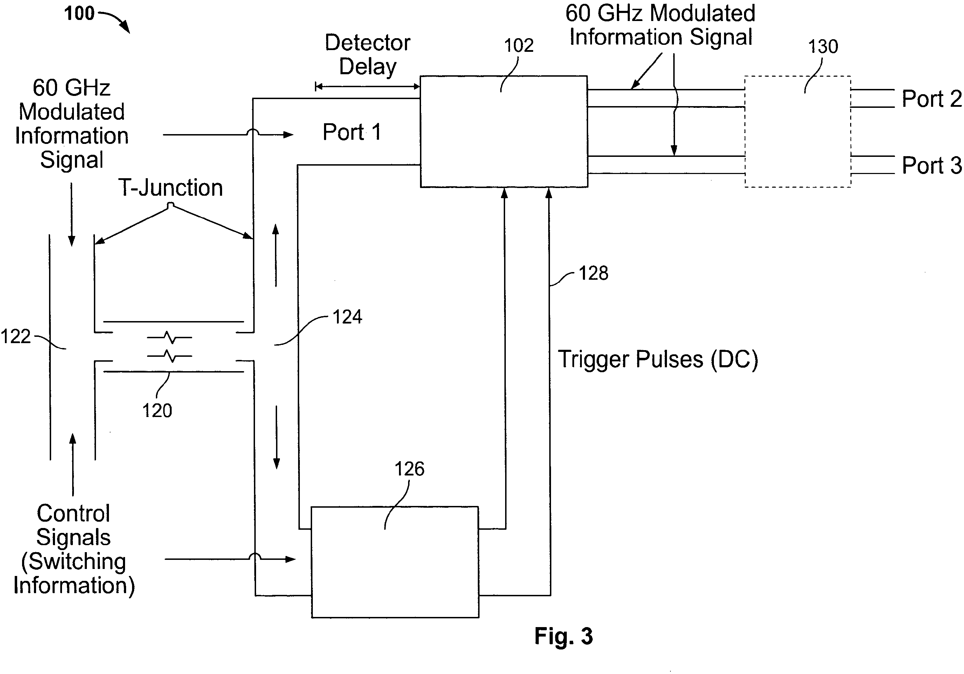

Fig. 3 shows further advantageous embodiment of a switching module 100 according to the present invention. According to this embodiment, the control signal responsible for the switching to a particular port can be dynamically allotted. The 60 GHz modulated information signal is input simultaneously with the control signal into a PMF 120 at a first T-junction 122. The PMF 120 transmits both the control signals and the high-frequency modulated signal. Via a second T-junction 124 the transmitted signal is input into the controllable switch 102 and into a detector unit 126.

The detector unit 126 extracts control signal from the received input and generates DC trigger pulses 128 that cause the controllable switch 102 to switch to either port 2 or to port 3. Accordingly, a propagation path is established between port 1 and one of the ports 2 or 3. This propagation path allows a full-duplex communication. Consequently, an optional second detector unit 130 may be provided to extract control signals that the transmitted from port 1 and/or port 3 with the signal flow being directed towards port 1.

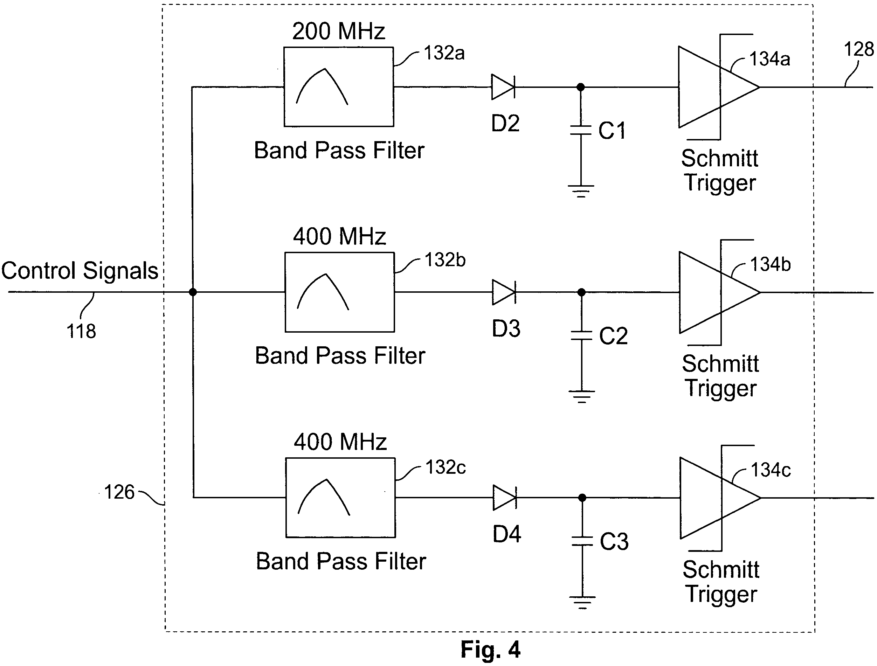

Fig. 4 illustrates a possible embodiment of a detector unit 126 according to the present invention. The detector unit 126 is able to extract control signals which are formed by a frequency encoded pulses. For instance, a pulse having a frequency of 200 MHz signifies a switching to port 2, whereas a pulse having a frequency of 400 MHz signifies switching to port 3. Band pass filters 132 extract the respective control signal and inputs it via a diode into a Schmitt trigger 134. Each of the Schmitt triggers 134 outputs a DC trigger pulse 128 when the respectively frequency encoded control signal is detected at the input of the detector unit 126.

Capacitors C1 to C3 stabilize the input for the Schmitt triggers 134a to 134c.

In summary, the present invention allows switching a high-frequency modulated signal without performing any up or down conversion steps and therefore reduces the complexity of the system and achieves a particularly low latency.

### REFERENCE NUMERALS

| **Reference Numeral** | **Description** |
|---|---|
| 100 | Switching module |
| 102 | Controllable switch |
| 104 | Link-management unit |
| 106 | Switching pulse |
| 108 | High-frequency modulated signal |
| 110 | Control signal generating unit |
| 112 | Inverter |
| 114 | Latch circuit |
| 116 | Control signal generator |
| 118 | Control signal |
| 120 | Polymer millimeter wave fiber (PMF) |
| 122 | First T-junction |
| 124 | Second T-junction |
| 126 | Detector unit |
| 128 | Trigger pulse |
| 130 | Second detector unit |
| 132a, 132b, 132c | Band pass filter |
| 134a, 134b, 134c | Schmitt trigger |

## Claims

1. Switching module for establishing a controllable propagation path for a high-frequency modulated signal in response to a switching information, wherein the switching module (100) comprises:
a controllable switch (102) for coupling a first port to one of at least a second port and an N^{th} port, N being an integer greater than or equal to 3, and
a link-management unit (104) that is operable to generate a control signal for controlling said switch (108) based on the switching information,
wherein the link-management unit (104) comprises a detector unit (126) that is operable to receive the control signal together with the high-frequency modulated signal and to generate a switching pulse (128) for controlling the switch (102) depending on the control signal.

2. Switching module according to claim 1, further comprising a control signal generating unit (110) having a latch circuit (114) having a data input terminal (D), a latch enable terminal (LE), and an output terminal (Q), wherein the high-frequency modulated signal is input into the data input terminal (D) and wherein the output terminal (Q) is connected to a control signal generator for triggering a control signal.

3. Switching module according to claim 1 or 2, wherein the controllable switch (102) comprises a GaAs monolithic microwave integrated circuit.

4. Switching module according to one of the preceding claims, wherein the detector unit (126) comprises at least a first and a second band pass filter (132) for receiving the control signal and at least a first and a second Schmitt trigger (134), the first Schmitt trigger (134a) being connected with its input to the output of the first band pass filter (132) for generating a trigger pulse (128) in response to an output signal being present at the output of the first band pass filter (132a), and the second Schmitt trigger (134b) being connected with its input to the output of the second band pass filter (132b) for generating a trigger pulse (128) in response to an output signal being present at the output of the second band pass filter (132a).

5. Switching module according to one of the preceding claims, further comprising a second detector unit (130) for detecting a control signal transmitted with a high-frequency modulated signal received at the second or third port, wherein the propagation path is a full-duplex transmission path.

6. Switching module according to one of the preceding claims, further comprising fiber coupling antennas for coupling a millimeter wave conducting fiber to each of the first, second, and third ports.

7. Switching module according to one of the preceding claims, wherein the control signal comprises pulses with different frequencies for encoding the switching information.

8. Switching module according to one of the preceding claims, further comprising power amplification means for amplifying the high-frequency modulated signal.

9. Method of establishing a controllable propagation path for a high-frequency modulated signal in response to a switching information, wherein the method comprises:
generating the control signal for controlling a controllable switch (102) based on the switching information,
coupling a first port to one of at least a second port and a third port by means of the controllable switch (102),
wherein the control signal is transmitted together with the high-frequency modulated signal and wherein a switching pulse (128) is generated for controlling the switch (102) depending on the control signal.

10. Method according to claim 9, wherein generating the switching pulse (128) comprises filtering the control signal and inputting the filtered control signal into a trigger stage (134a - 134c), wherein the trigger stage generates the switching pulse.

11. Method according to one of the claims 9 or 10, wherein the control signal is generated from switching information transmitted with the high-frequency modulated signal over a millimeter wave fiber.

12. Method according to one of the claims 9 or 10, wherein the control signal is generated from switching information transmitted simultaneously with the high-frequency modulated signal over a wireless communication channel.

13. Method according to one of the claims 9 to 12, wherein the control signal is generated as a frequency multiplexed or code multiplexed signal.

14. Method according to one of the claims 9 to 13, wherein the controllable propagation path is a full-duplex transmission path.
